# EUROPEAN PATENT APPLICATION

(11) **EP 2 902 394 A1**
(43) Date of publication of application: **05.08.2015**
(21) Application number: 14305114.2
(22) Date of filing: 29.01.2014
(51) Int. Cl.: C07F 9/00, C23C 16/455, H01L 21/285

(54) **Vanadium organic precursors and their use for vapor phase deposition of vanadium containing films**

(71) Applicant: L'AIR LIQUIDE, SOCIETE ANONYME POUR L'ETUDE ET L'EXPLOITATION DES PROCEDES GEORGES CLAUDE, 75007 Paris (FR)
(72) Inventor: Correia Anacleto, Antony, 94000 CRETEIL (FR); Lachaud, Christophe, 91240 SAINT-MICHEL SUR ORGE (FR); Pinchart, Audrey, 31680 LABEGE (FR); Zauner, Andreas, 78960 VOISINS LE BRETONNEUX (FR)
(74) Representative: Grout de Beaufort, François-Xavier

(57) **Abstract**

Compounds of formula (I) : M(R₁CS₂)R₂R₃NR₆ 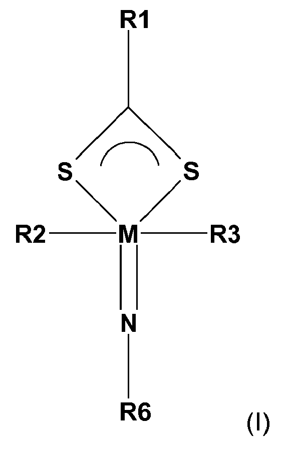 R₁, R₂, R₃ are organic ligands being independently selected in H, C1-C4 alkyl group linear or branched, aryl group, silyl group, alkylamine group, alkylsylilamine group.
R₆ is an organic ligand being independently selected in H, C1-C4 alkyl group linear or branched, aryl group, silyl group, alkylsylilamine group.
M is Vanadium.

## Description

The invention relates to new compounds and method for forming a vanadium containing layer on a substrate.

With the continuous shrink of the critical dimensions in the modern semiconductor devices, the introduction of new materials is becoming crucial to implement in the future generation and node technology. Vanadium based materials are of particular interest for three main applications.

Vanadium metal containing films find an application in back-end-of-the-line (BEOL) layers as metal diffusion barriers. In order to prevent the diffusion of copper among the circuits and ensure an adequate adhesion of the layer to silicon and to the low-k matrix, it is well acknowledged that a barrier layer such as Ta on TaN is needed. Nitrogen incorporation also helps to reduce the copper diffusion. Tantalum films are currently deposited using a sputter deposition method to achieve a low-k/TaN-Ta/Cu patterned structure. With the shrinkage of the chip dimensions, sputtering will quickly become inadequate for conformal depositions.

Besides, group V (Ta, Nb, V) metal containing films are candidates to replace polysilicon as CMOS gate. With the continuous scaling of devices, polydepletion contributes significantly to the CET. Besides that, Fermi level pinning occurs while using polysilicon on dielectric materials of high permittivity (high-k's).

By introducing metal gates, the polydepletion is avoided and it is possible to obtain gates for PMOS and NMOS devices. The requirements for a suitable metal gate material generally include: lowest resistivity possible, thermal stability, good adhesion on the gate oxide, etch selectivity and suitable work-function. Ideally, one would like two metal compounds with band-edge work-functions as about 5.1 eV for pMOS gate and about 4.1 eV for nMOS gate. Group V (Ta, Nb, V) metal containing films, and in particular tantalum based materials such as tantalum carbide, tantalum nitride, tantalum carbo-nitride, tantalum silicide, tantalum silico-carbide, tantalum silico-nitride, show promising properties for metal gate application. TaCN has been suggested as a suitable pMOS metal. TaCN work function was estimated to 4.8-5eV.

Besides, group V (Ta, Nb, V) metal containing films are used as electrodes (in the case of pure metal or metal nitride), and also as high-k layers (in the case of oxide) in the Metal-Insulator-Metal structures (DRAM, etc...). In particular, TaN is a promising candidate for electrodes, and Ta₂O₅ and TaOₓN_{y} for high-k layers.

The main industrial options to enable the deposition of such thin films with reasonable throughput and acceptable purity are vapor phase deposition techniques, such as MOCVD (Metal Organic Chemical Vapor Deposition) or ALD (Atomic Layer Deposition).

For instance, ALD or Plasma-Assisted Atomic layer Deposition (PA-ALD) is generally considered as a suitable method to form the highly conformal films needed for BEOL applications or DRAM capacitors, when associated with a relevant precursor. Metal organic and halide compounds are required for those processes.

Many Group V (Ta, Nb, V) precursors have been considered to enable such deposition.

Examples can be given as follows:
Halides such as TaCl₅ have been widely investigated such as disclosed in US6,268,288 by Hautala et al.. However, some by-products generated during the deposition process, such as HCl or Cl₂, can cause surface/interface roughness that can be detrimental to the final properties. Moreover, Cl or F impurities can be detrimental to the final electrical properties. It is therefore expected to find new compounds having sufficient volatility without containing Cl, F, or Br atoms.

Alkylamides and alkylimides, such as Ta(NMe₂)₅ (PDMAT), Ta(=NtBu)(NEt₂)₃ (TBTDET), Ta(=NiPr)(NMe₂)₃ (IPTDMT), Ta(=NCH₂C(CH₃)₃)(NEt₂)₃ (TAIMATA), Ta(=NiPr)(NEt₂)₃ (IPTDET) have been considered. Those precursors present the advantages of being frequently liquid at room temperature, like TBTDET, and having fair volatility, sufficient shelf-life and thermal stability. Urdahl et al. have also proposed TBTDET for the deposition of Ta₂O₅ in WO02/20870. TAIMATA has been first proposed by Yasuhara et al. in US6,593,484. A method of deposition of tantalum nitride films by sequential injection of TBTDET or TAIMATA and other N source is disclosed in US2004/0219784. A method and apparatus of generating PDMAT precursor has been proposed by Chen et al. in US2004/0014320 A1.

However, these precursors, and in particular the PDMAT, are not suitable for the deposition of conductive TaN layers without assisting the thermal ALD process by plasma techniques.

The inventors have concluded from the background of the invention that new metal-organic precursors for the deposition of metal-containing films for applications in the semiconductor industry are required.

In particular, new vanadium organic precursors are needed for the deposition by vapor phase of pure metal, metal carbide, metal nitride, metal carbo-nitride, metal silicide, metal silico-carbide, metal silico-nitride and metal oxides.

Those films are highly desirable for application in the semiconductor industry either as:
- Copper diffusion barrier in BEOL applications;
- CMOS metal gate;
- High-k layers in memory devices;
- Electrodes for Metal-Insulator-Metal applications (DRAM, etc...).

The present invention introduces novel thermally stable vanadium organic precursors and their use to deposit vanadium containing thin films by either ALD, MOCVD or chemical vapor deposition techniques assisted plasma.

The novel metal-organic compounds have the original characteristic of containing only one dithiocarbamate ligand. The general formula is (I):

M(R₁CS₂)R₂R₃NR₆

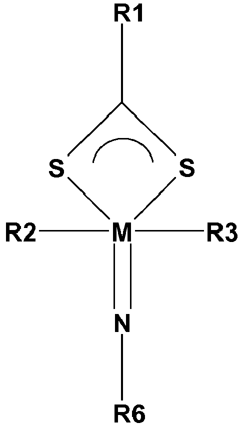

R₁, R₂, R₃ are organic ligands being independently selected in H, C1-C4 alkyl group linear or branched, aryl group, silyl group, alkylamine group, alkylsylilamine group.
R₆ is an organic ligand being independently selected in H, C1-C4 alkyl group linear or branched, aryl group, silyl group, alkylsylilamine group.
M is Vanadium.

According to the inventors this novel family of metal-organic compounds has attractive thermal properties. The proposed new metal-organic precursors present the advantages of:
- being thermally stable enough to enable proper distribution (gas phase or direct liquid injection) without particles generation,
- being thermally stable enough to allow wide self-limited ALD window,
- allowing the deposition of a variety of vanadium containing films, including, ternary or quaternary materials, by using one or a combination of co-reactants.

Co-reactants are selected without limitation among the group consisting of H₂, NH₃, O₂, H₂O, O₃, SiH₄, Si₂H₆, Si₃H₈, TriDMAS, BDMAS, BDEAS, TDEAS, TDMAS, TEMAS, (SiH₃)₃N, (SiH₃)₂O, TMA or any other element in the group II, III-A, III-B, Sulphur (S), transition metal, lanthanoids, or rare-earth metals.

According to another embodiment, the present invention concerns the following compounds:

V(NEt₂CS₂)(NEt₂)₂(NtBu);

V(NMe₂CS₂)(NMe₂)₂(NtBu);

V(N(EtMe)CS₂)(N(EtMe))₂(NtBu).

According to another embodiment, the present invention concerns a method for forming a vanadium-containing layer on a substrate, the method comprising at least the steps of:
a) providing a vapor comprising at least one precursor compound as defined above;
b) reacting the vapor comprising the at least one compound of formula (I) with the substrate, according to a process selected between an atomic layer deposition process, a MOCVD (Metal-Organic Chemical Vapor Deposition) process, vapor phase deposition methods assisted by plasma techniques like Plasma-Enhanced Chemical Vapor Deposition (PECVD) or Plasma-Enhanced Atomic Layer Deposition (PEALD), to form a layer of a vanadium-containing complex on at least one surface of said substrate.

According to another embodiment, the present invention concerns a method as defined above wherein the process of step b) is an atomic layer deposition process.

According to another embodiment, the present invention concerns a method as defined above further comprising the step:
c) reaction of the complex formed obtained in step b) with a reagent selected from another metal source, reducing reactants and/or nitriding reactants and/or oxidizing reactants.

According to another embodiment, the present invention concerns a method as defined above wherein the vapour provided in step a) further comprises one or more metal (M')-organic precursor(s) to produce thin films containing vanadium and M'.

According to another embodiment, the present invention concerns a method as defined above further comprising providing at least one reaction gas wherein the at least one reaction gas is selected from the group consisting of hydrogen, hydrogen sulfide, hydrogen selenide, hydrogen telluride, carbon monoxide, ammonia, organic amine, silane, disilane, higher silanes, silylamines, diborane, hydrazine, methylhydrazine, chlorosilane and chloropolysilane, metal alkyl, arsine, phosphine, trialkylboron, oxygen, ozone, water, hydrogen peroxide, nitrous oxide, nitrogen monoxide, nitrogen dioxide, alcohols, plasma comprising fragments of those species, and combinations thereof, preferably ozone or water.

According to another embodiment, the present invention concerns a method of manufacturing a semiconductor structure, comprising the steps of the method defined above, wherein the substrate is a semiconductor substrate.

In one embodiment of the invention, the new molecules have preferably a melting point lower than 100°C i.e. which is liquid or can be easy liquefied for easy delivery.

In one embodiment of the invention, the new molecules have preferably a vapor pressure higher than 13Pa at 130°C.

### Method of depositing vanadium containing films: M¹, M¹C, M¹CN, M¹Si, M¹SiN, M¹₂O₅, M¹OₓN_{y} M¹M²OₓN_{y}.

A method for forming a vanadium containing film comprising the steps of:
- Vaporizing a metal source to form a gas phase metal source;
- Feeding a plurality of precursors in vapor phase to a deposition device, wherein said precursors comprise said vaporized metal source, and may comprise without limitation another metal source, an oxygen source, a nitrogen source, a carbon source; and forming a metal containing film.

In one embodiment of the invention, the vaporization of the new metal-organic compound is realized by introducing a carrier gas into a heated container containing the said new metal source. The container is preferably heated at a temperature allowing to get the said metal source in liquid phase and at a sufficient vapor pressure. The carrier gas can be selected, without limitation, from Ar, He, H₂, N₂ or mixtures of them. The said metal source can be mixed to a solvent or a mixture of solvent, to another metal source or to a mixture of them in the container. The container can for instance be heated at temperatures in the range of 20°C-200°C. Those skilled in the art will consider that the temperature of the container can be adjusted to control the amount of precursor vaporized.

In another embodiment of the invention, the said metal source is fed in liquid state to a vaporizer where it is vaporized. The said metal source can be mixed to another metal source. The said mixture of metal sources can be mixed to a solvent or a mixture of solvent. The said metal source can be mixed to a stabilizer. The said solvent can be selected in the group consisting of alcanes such as hexane, heptane, octane, aromatic solvents such as benzene, toluene, mesitylene, xylene, silicon containing solvent such as hexamethyldisiloxane, hexamethyldisilazane, tetramethylsilane, sulphur containing solvents such as dimethylsulfoxide, oxygen containing solvent such as tetrahydrofuran, dioxane.

The said vaporized metal source is introduced into a reaction chamber where it is contacted to a substrate. The substrate can be selected in the group consisting of Si, SiO₂, SiN, SiON, W containing film or other metal containing films. The substrate can be heated to sufficient temperature to obtain the desired film at sufficient growth rate and with desired physical state and composition. Typical temperature range is from 150°C to 600°C. Preferably the temperature is lower or equal to 450°C. The pressure in the reaction chamber is controlled to obtain the desired metal containing film at sufficient growth rate. The typical pressure range is from 0.13 Pa level to 13 kPa or higher.

In one embodiment of the invention, the said metal source is mixed to a reactant specie prior to the reaction chamber.

In another embodiment of the invention, the said metal source and the reactant species are introduced sequentially in the reaction chamber. The said metal source and the reactant species can be introduced simultaneously (chemical vapor deposition), sequentially (atomic layer deposition) or different combinations. One example is to introduce metal source and the other metal source together in one pulse and ammonia in a separate pulse [modified atomic layer deposition]; another example is to introduce the reactant species (one example could be oxygen) continuously and to introduce metal source by pulse (pulsed-chemical vapor deposition).

In one embodiment of the invention, the reactant species are passed through a plasma system localized remotely from the reaction chamber, and decomposed to radicals.

In one embodiment of the invention where the targeted metal based film contains oxygen, such as for example metal oxide or metal oxy-nitride, the said reactant species include an oxygen source which is selected from, oxygen (O₂), oxygen radicals (for instance O^{.} or OH^{.}), for instance generated by a remote plasma, ozone (O₃), NO, N₂O, NO₂, moisture (H₂O) and H₂O₂.

In one embodiment of the invention where the targeted metal based film contains nitrogen, such as for example metal nitride or metal carbo-nitride, the said reactant species include a nitrogen source which is selected from nitrogen (N₂), ammonia, hydrazine and alkyl derivatives, N-containing radicals (for instance N^{.}, NH^{.}, NH₂^{.}), NO, N₂O, NO₂, amines.

In one embodiment of the invention where the targeted metal based film contains carbon, such as for example metal carbide or metal carbo-nitride, the said reactant species include a carbon source which is selected from methane, ethane, propane, butane, isobutane, ethylene, propylene, isobutylene, CCl₄.

In one embodiment of the invention where the targeted metal based film contains silicon, such as for example metal silicide, silico-nitride, silicate, silico-carbo-nitride, the said reactant species include a silicon source which is selected from SiH₄, Si₂H₆, Si₃H₈, TriDMAS, BDMAS, BDEAS, TDEAS, TDMAS, TEMAS, (SiH₃)₃N, (SiH₃)₂O, trisilylamine, disiloxane, trisilylamine, disilane, trisilane, a alkoxysilane SiHₓ(OR¹)₄₋ₓ, a silanol Si(OH)ₓ(OR¹)₄₋ₓ (preferably Si(OH)(OR¹)₃; more preferably Si(OH)(OtBu)₃ an aminosilane SiHₓ(NR¹R²)₄₋ₓ (where x is comprised between 0 and 4; R¹ and R² are independently H or a C1-C6 carbon chain, either linear, branched or cyclic); preferably TriDMAS SiH(NMe₂)₃, BTBAS SiH₂(NHtBu)₂; BDEAS SiH₂(NEt₂)₂ and mixtures thereof.

The targeted film can alternatively contain Germanium. The above-mentioned Si containing sources could be replaced by Ge containing sources.

In one embodiment of the invention, the said metal source is mixed to another metal source to deposit a multi-metal containing film.

In one embodiment of the invention, the said metal sources are simultaneously introduced and mixed into the reaction chamber.

In another embodiment of the invention, the said metal sources are simultaneously introduced and mixed to reactant species into the reaction chamber.

In one embodiment of the invention, the said metal-organic molecule is used for atomic layer deposition of metal-containing films. The said first metal source, the possible said second metal source and the reactant species are introduced sequentially in the reaction chamber (atomic layer deposition). The reactor pressure is selected in the range from 0.13 Pa to 13 kPa. Preferably, the reactor pressure is comprised between 133 Pa and 1333 Pa. A purge gas is introduced between the metal source pulse and the reactant species pulse. The purge gas can be selected without limitation from the group consisting of N₂, Ar, He. The metal source, purge gas and reactant species pulse duration is comprised between 0.1 s and 100 s. Preferably the pulse duration is comprised between 0.5 sand 10s.

In one embodiment of the invention, the second metal source is selected independently and without limitation selected from any other element in the group II, III-A, III-B, Sulphur (S), transition metal, lanthanoids, or rare-earth metals.

### 1. EXAMPLES

### A. New vanadium organic precursors containing one dithiocarbamate ligand

Examples of new vanadium organic precursors disclosed in the present invention include :

V(NEt₂CS₂)(NEt₂)₂(NtBu);

V(NMe₂CS₂)(NMe₂)₂(NtBu);

V(N(EtMe)CS₂)(N(EtMe))₂(NtBu).

### B. Synthesis of (N,N diethyldithiocarbamato)(diethylamido)(tert-butylimino)vanadium

- V(NEt₂CS₂)(NEt₂)₂(NtBu) is prepared in one step:
- tBuN=V(NEt₂)₃ is added to Et₂NCS₂H in equimolar proportion under hexane. The result is V(NEt₂CS₂)(NEt₂)₂(NtBu) with HNEt₂. The crude result is purified.

The reaction leads to V((NEt₂CS₂)(NEt₂)₂(NtBu).

### C. CVD process using V(NEt₂CS₂)(NEt₂)₂(NtBu) and ammonia

V(NEt₂CS₂)(NEt₂)₂(NtBu) is stored into a container. The container is heated at 100°C and N₂ is used as carrier gas at a flow of 50sccm. Ammonia (NH₃) is used as nitrogen source. The substrate is heated at 400°C. The precursor is simultaneously introduced into the reaction chamber with NH₃. A film of vanadium nitride is obtained.

### D. ALD process using V(NEt₂CS₂)(NEt₂)₂(NtBu) and ammonia

V(NEt₂CS₂)(NEt₂)₂(NtBu) is stored into a container. The container is heated at 100°C and N₂ is used as carrier gas at a flow of 50sccm. Ammonia (NH₃) is used as nitrogen source. The substrate is heated at 400°C. The precursor is sequentially introduced into the reaction chamber with NH₃: during the first step a pulse of V((NEt₂CS₂)(NEt₂)₂(NtBu) is introduced during 2s, followed by a 5s N₂ purge. A pulse of NH₃ is then introduced into the reaction chamber during 2s, followed by a 5s N₂ purge. The first step is then done again. 1000 cycles are performed this way. A film of vanadium nitride is obtained.

## Claims

1. Compounds of formula (I): M(R₁CS₂)R₂R₃NR₆ 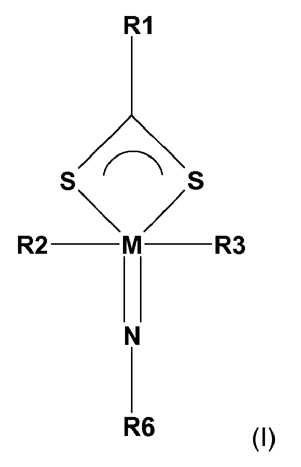
R₁, R₂, R₃ are organic ligands being independently selected in H, C1-C4 alkyl group linear or branched, aryl group, silyl group, alkylamine group, alkylsylilamine group.
R₆ is an organic ligand being independently selected in H, C1-C4 alkyl group linear or branched, aryl group, silyl group, alkylsylilamine group.
M is Vanadium.

2. The following compounds:
V(NEt₂CS₂)(NEt₂)₂(NtBu);
V(NMe₂CS₂)(NMe₂)₂(NtBu);
V(N(EtMe)CS₂)(N(EtMe))₂(NtBu).

3. A method for forming a vanadium-containing layer on a substrate, the method comprising at least the steps of:
a) providing a vapor comprising at least one precursor compound as defined in one of claims 1 or 2;
b) reacting the vapor comprising the at least one compound of formula (I) with the substrate, according to a process selected between an atomic layer deposition process, a MOCVD (Metal-Organic Chemical Vapor Deposition) process, vapor phase deposition methods assisted by plasma techniques like Plasma-Enhanced Chemical Vapor Deposition (PECVD) or Plasma-Enhanced Atomic Layer Deposition. (PEALD), to form a layer of a vanadium-containing complex on at least one surface of said substrate.

4. The method of claim 3 wherein the process of step b) is an atomic layer deposition process.

5. The method of claim 4, further comprising the step:
c) reaction of the complex formed obtained in step b) with a reagent selected from another metal source, reducing reactants and/or nitriding reactants and/or oxidizing reactants.

6. The method of any one of claims 3 to 5, wherein the vapour provided in step a) further comprises one or more metal (M')-organic precursor(s) to produce thin films containing vanadium and M'.

7. The method of any one of claims 3 to 6, further comprising providing at least one reaction gas wherein the at least one reaction gas is selected from the group consisting of hydrogen, hydrogen sulfide, hydrogen selenide, hydrogen telluride, carbon monoxide, ammonia, organic amine, silane, disilane, higher silanes, silylamines, diborane, hydrazine, methylhydrazine, chlorosilane and chloropolysilane, metal alkyl, arsine, phosphine, trialkylboron, oxygen, ozone, water, hydrogen peroxide, nitrous oxide, nitrogen monoxide, nitrogen dioxide, alcohols, plasma comprising fragments of those species, and combinations thereof, preferably ozone or water.

8. A method of manufacturing a semiconductor structure, comprising the steps of the method defined in any one of claims 3 to 7, wherein the substrate is a semiconductor substrate.
